# EUROPEAN PATENT APPLICATION

(11) **EP 4 546 313 A1**
(43) Date of publication of application: **30.04.2025**
(21) Application number: 23924702.6
(22) Date of filing: 07.03.2023
(51) Int. Cl.: G09F 9/30

(54) **ROLL-UP SCREEN**

(30) Priority: 02.03.2023 CN 202310190465
(71) Applicant: Onumen Technology Co., Ltd., Shenzhen, Guangdong 518000 (CN)
(72) Inventor: WANG, Ning, Shenzhen, Guangdong 518000 (CN); LIU, Yanping, Shenzhen, Guangdong 518000 (CN)
(74) Representative: Sun, Yiming
(86) International application number: PCT/CN2023/079976
(87) International publication number: WO 2024/178736

(57) **Abstract**

The present invention discloses a rolling-up screen, which comprises: a roller holder connected to a ceiling by means of a frame, or supported by a frame; a roller rotatably connected between a left-side plate and a right-side plate of the roller holder; a screen including display units that are connected to one another upwards and downwards in multiple rows and connected with the roller by means of hanging steel wire, wherein the screen can be wound around the roller after retracting, and suspended below the roller by the hanging steel wire after unfolding; a driving assembly arranged on the roller holder and connected with the roller, wherein the driving assembly is used to drive the roller to rotate, so as to enable the screen to be retracted and wound on the roller or unfolded and hung below the roller; and multiple groups of supporting protection pieces arranged on the back surfaces of the display units in each row, and used to protect the display units during retracting the screen. **In** present invention, an entire frame board bar is installed behind display units in each row, the frame board is caught and fixed by fasteners to ensure that display units in each row are flat, the buffering pad is mounted on the rear of both ends of the frame board bar, and when the screen is rolled, the lamp beads of the display units are not squeezed under the support of the buffering pad.

## Description

### FIELD OF THE INVENTION

The present invention relates to the technical field of screens for displaying, in particular to a rolling-up screen.

### BACKGROUND OF THE INVENTION

In large malls, or official places such as conference rooms, it is often necessary to use a large screen to display products or paperwork results. If a fixed screen is disposed directly, it will undoubtedly take up a lot of indoor space; therefore, some screens adapted to storage, which can be unfolded when in use and retracted when not in use so as to reduce occupation of indoor space, such as rolling-up screens, have been launched on the market. The rolling-up screen is simple and reliable in adaption for storage by the way winding a flexible screen around a roller. In the process of rolling a current rolling-up screen for storage, it is easy to damage lamp beads of the screen, so as to affect display effect.

### SUMMARY OF THE INVENTION

In order to solve the technical problem in the above-mentioned prior art, the present invention provides a rolling-up screen.

The technical scheme adopted in the present invention is to provide a rolling-up screen, it comprises:
a roller holder connected to a ceiling by means of a frame, or supported by a frame;
a roller rotatably connected between a left-side plate and a right-side plate of the roller holder;
a screen including display units that are connected to one another upwards and downwards in multiple rows and connected with the roller by means of hanging steel wire, wherein the screen can be wound around the roller after retracting, and hung below the roller by the hanging steel wire after unfolding;
a driving assembly arranged on the roller holder and connected with the roller, wherein the driving assembly is used to drive the roller to rotate, so as to enable the screen to be retracted and wound on the roller or unfolded and hung below the roller; and
multiple groups of supporting protection pieces arranged on back surfaces of the display units in each row, and used to protect the display units during retracting the screen.

The supporting protection piece includes frame board bars arranged on the back surfaces of the display units in each row; and supporting buffering pads arranged at both ends of each of the frame board bars and beyond the positions of the display units, so that at the time of retracting the screen, one supporting buffering pad supports a frame board bar of another supporting protection piece, or stays against the roller.

Further, a rubber piece is trapped within a gap between two adjacent ones of the frame board bars.

Further, a hanging groove is set on an inner wall of the roller in the axis direction, the hanging groove is used to trap a hanging head of the hanging steel wire, and the hanging head is used to connect with the hanging steel wire.

Further, safety steel wire hanging on the roller is installed on both sides of the back surface of the screen, and deformation of the safety steel wire is less than that of the hanging steel wire.

Further, a cable-arrangement groove is set on an inner wall of the roller in the axis direction, a plurality of cable outlets leading to the cable-arrangement groove are set on an outer surface of the roller, and both sides of the cable outlet on the roller are sleeved with rubber sleeves.

Specifically, the driving assembly includes a motor that is arranged on the right-side plate of the roller holder and positioned at one end of the roller, and a rotating shaft of the motor is inserted into the roller and connected with the roller.

Further, the other end of the roller holder is arranged on the left-side plate of the roller holder, a bearing is arranged on the left-side plate, an inner ring of the bearing is fixedly connected with the left-side plate, and an outer ring of the bearing is connected with an end portion of the roller by means of a connector.

The present invention further comprises a motor-protecting mechanism which includes:
reel partitions that are arranged on both sides of the outer ring of the bearing, wherein the outer ring of the bearing and two of the two reel partitions form a reel;
a deflection sheave seat and a spring-fixing piece that are arranged on the frame; and
counterweight steel wire getting turned via the deflection sheave seat, one end of which is connected with the reel, and the other end of which is connected with a spring on the spring-fixing piece.

Side pulleys are arranged on both sides of the screen; and a vertical guide rail in correspondence with the side pulleys is arranged on the frame.

Compared with the prior art, the present invention has the following advantages.
1. An entire frame board bar is installed behind display units in each row, the frame board is caught and fixed by buckles to ensure that display units in each row are flat, the buffering pad is mounted on the rear of both ends of the frame board bar, and when the screen is rolled, the lamp beads of the display units are not squeezed under the support of the buffering pad.
2.By the way of setting up the motor-protecting mechanism, the counterweight spring continues to change its tensile force in correspondence with the tightening of the steel wire, so as to just offset changes in torque of rolling the screen, so that the motor always maintains a low load torque to work, making it possible to reduce the load of the motor, and making the motor run more smoothly.
3.The roller is sleeved with the rubber sleeves at intervals, the flat cable is arranged in the gaps between the rubber pads, so that when the screen curls, the flat cable is correspondingly curled in the gaps between the rubber pads, so as to ensure that the flat cable will not be crushed.
4.The safety steel wire is fixed on both sides of the screen, when the screen curls, the safety steel wire are correspondingly curled, and the deformation of the safety steel wire is less than that of the connecting steel wire inside the display units, so that the force during curling is borne by the safety steel wire, so as to achieve the purpose of protecting the connecting steel wire inside the display units.
5.Two modes of rolling up are given to ensure that the roller rotates properly and is free of influence of cables.
6.The upper-and-lower limit-stroke switch built in the motor can be adjusted by the user, and most of the motors are disposed inside the roller; the tail of the motor is sleeved with the tail bearing, and the rotating shaft is inserted into the roller and directly connected to the roller; in this way, the roller only has a rotating force and no tangential force during rotating.

### BRIEF DESCRIPTION OF THE DRAWINGS

To describe the technical solutions in the embodiments of the present invention more clearly, the following briefly introduces the accompanying drawings required for describing the embodiments. Apparently, the accompanying drawings in the following description show merely some embodiments of the present invention, and a person of ordinary skill in the art may still derive other drawings from these accompanying drawings without creative efforts.
Fig.1 is a 3D structural diagram for one embodiment of the present invention.
Fig.2 is a 3D structural diagram of one side of a partial area of the display unit in one embodiment of the present invention.
Fig.3 is a 3D structural diagram of another side of a partial area of the display unit in one embodiment of the present invention.
Fig.4 is a view showing an end face of the roller in one embodiment of the present invention.
Fig.5 is a structural diagram of the motor-protecting structure in one embodiment of the present invention.
Fig.6 is a structural diagram of partial parts on the area of the right-side plate in one embodiment of the present invention.
Fig.7 is a structural diagram of partial parts on the area of the left-side plate in one embodiment of the present invention.
Fig.8 is a structural diagram of partial parts on the area of the left-side plate in another embodiment of the present invention.
Fig.9 is a structural diagram of the curled screen in one embodiment of the present invention.

1-roller holder; 11- left-side plate; 12- right-side plate; 2-frame; 3-roller; 31- hanging groove; 32- cable-arrangement groove; 33-rubber sleeve; 34-position-restricting groove; 4-screen; 41-display unit; 42- hanging steel wire; 43- safety steel wire; 51-motor; 52- transmission sleeve; 53- internally-threaded connecting column; 54- tail bearing; 511- rotating shaft; 61-frame board bar; 62-supporting buffering pad; 63-side pulley; 64- rubber piece; 71- bearing; 72- catching claw; 81-reel partition; 82-counterweight steel wire; 83- spring-fixing piece; 84- spring; 85- deflection sheave seat; 91- power supply cord; 92- round rod; 93- jaw disc; 94- flat cable; 101- winding disc; 104- winding disk cover.

### DETAILED DESCRIPTION OF SOME EMBODIMENTS

In order to make the technical problem, technical solution and beneficial effect to be solved by the present invention more clearly understood, we shall further describe the present invention in detail in combination with the drawings and examples as follows. It should be understood that the specific examples described herein are only used to explain the present invention, not to pose a limitation on the present invention.

We shall describe the principle and structure of the present invention in detail in combination with the figures and embodiments as follows.

The current rolling-up screen cannot provide enough protection for the screen and the motor, in view of this, the present invention proposes a rolling-up screen, which can protect the screen and the motor, and improve the safety performance of the screen.

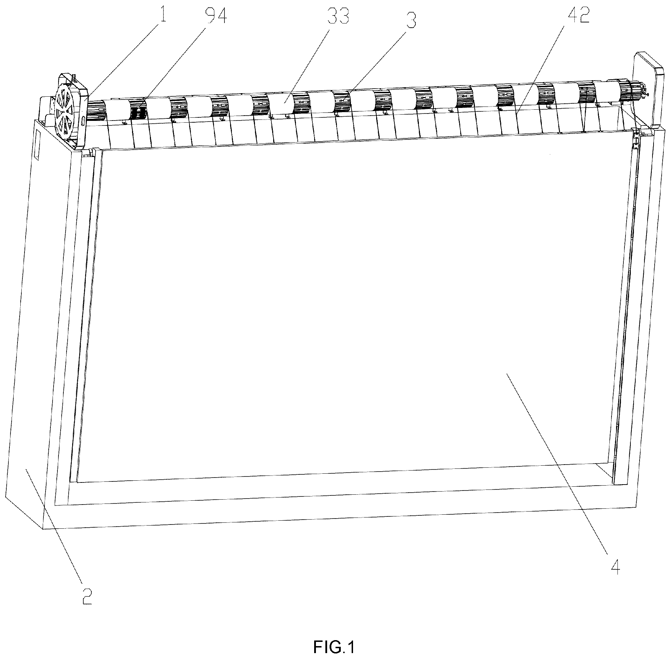

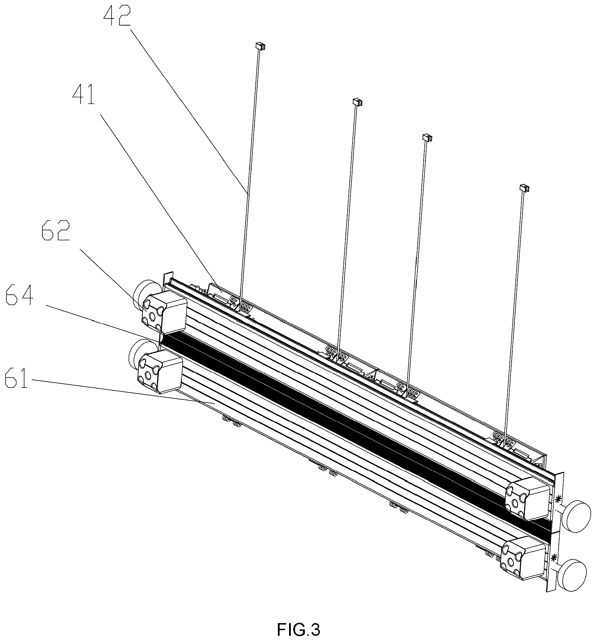

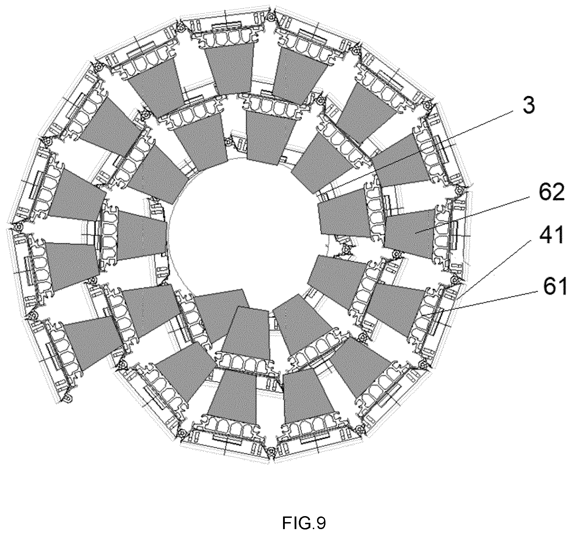

As shown in Figs.1-9, the rolling-up screen proposed by the present invention includes a roller holder 1, a frame 2, a roller 3, a screen 4, a driving assembly and supporting protection pieces. The roller holder 1 is supported by means of the frame 2, and the frame 2 is set upright. The roller holder 1 includes a left-side plate 11 and a right-side plate 12, and the left-side plate 11 and the right-side plate 12 are installed opposite to each other and spaced with each other on both sides of the top of the frame 2. The roller 3 is rotatably connected between the left-side plate 11 and the right-side plate 12 of the roller holder 1, and both ends of the roller 3 penetrate these two plates and can rotate around its axis. The screen 4 includes display units 41 that are connected to one another upwards and downwards in multiple rows, and two adjacent ones of these display units 41 are rotatably connected with each other. The back of the screen 4 is provided with a plurality of pieces of hanging steel wire 42 spaced with one another transversely, and each piece of hanging steel wire 42 passes through a fixed pressing block (no mark for it, not visible in the figure as blocked by a frame board bar 61, it is a seat body with vertical steel wire holes) set on the back of each display unit 41 from top to bottom in turn. A top end of the hanging steel wire 42 is connected with the roller 3, and when the screen 4 needs to be retracted, the driving assembly drives the roller 3 to rotate in one direction, so that the hanging steel wire 42 is wound on the roller 3, and drive the display units 41 of the screen 4 in each row to be sequentially rolled up around the roller 3; when the screen 4 needs to be unfolded, the driving assembly drives the roller 3 to rotate in another direction, so that the screen 4 that has been wound around the roller 3 is unfolded downwards, and the screen 4 that has been unfolded is hung directly below the roller 3 by the hanging steel wire 42. A driving device is arranged on the right-side plate 12 and used to drive the roller 3 to rotate, so as to enable the screen 4 to be retracted and wound on the roller 3 or unfolded and hung below the roller 3. The supporting protection pieces are arranged on the backs of the display units 41 in each row, and used to protect the lamp beads of the display units during retracting the screen, and flatten the display units transversely.

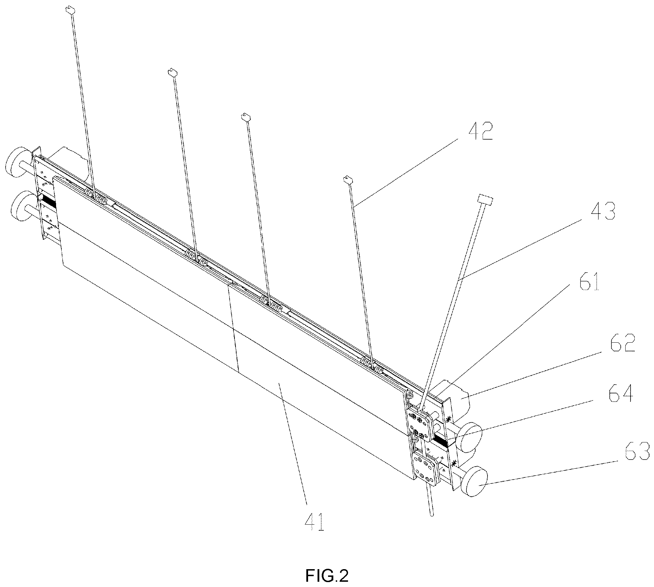

As shown in Figs.2,3 and 9, each group of supporting protection pieces includes a frame board bar 61 and two supporting buffering pads 62, the frame board bar 61 is transversely buckled on the backs of display units 41 in one row, so that the display units 41 in an identical row keep flat to guarantee display effect. The length of the frame board bar 61 is bigger than the length of display units 41 in one row, so that both ends of the frame board bar 61 are beyond any one of the display units 41 by one section; the two supporting buffering pads 62 are respectively mounted on the backs of both ends of the frame board bar 61, and the height of each of the supporting buffering pads 62 may be bigger than the thickness of any one of the display units 41. When the screen 4 is retracted and wound, the supporting buffering pads 62 on the backs of the frame board bars 61 in several rows positioned above, press on the roller 3, while the supporting buffering pads 62 on the backs of the rest of frame board bars 61 stay against the front surfaces of the former frame board bars 61 positioned at both ends, so that the screen 4 dos not get squeezed, and the lamp beads set on the backs of display units 41 get protected, improving the reliability of the rolling-up screen.

As one embodiment, a rubber piece 64 is sandwiched between two adjacent frame board bars 61, and the rubber piece 64 can block the gap between the display units 41 and prevent light transmission. In addition, when the screen 4 is wound, the rubber piece can function as a buffer, and avoid the two frame board bars 61 adjacent to each other upwards and downwards from directly colliding with each other and causing deformation with squeezes.

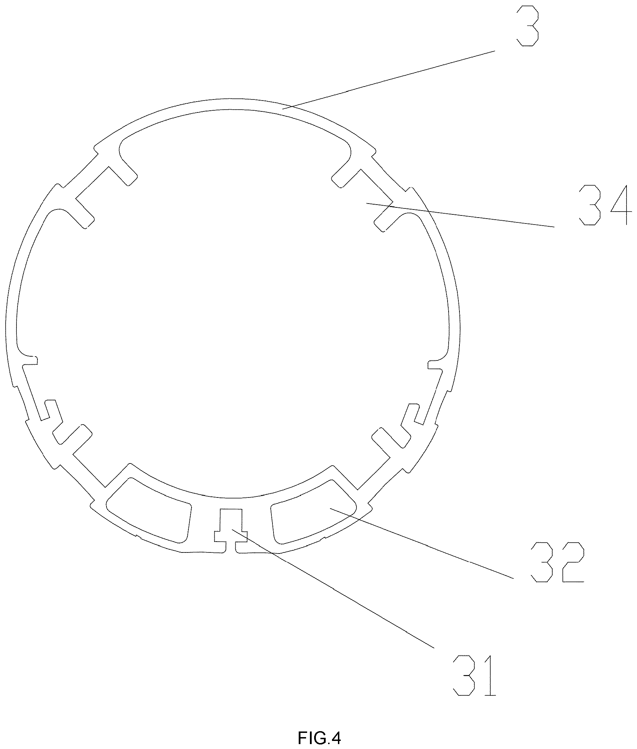

As one embodiment, as shown in Fig.4, the circumferential surface of the roller 3 is provided with a hanging groove 31 in the axis direction, and the hanging groove 31 stretches from one end face of the roller 3 to the other end of the roller 3. The top end of the hanging steel wire 42 is connected with a square hanging head, which is slid into the hanging groove 31 from an end portion of the hanging groove 31 during installation; the hanging steel wire 42 stretches out from a notch of the hanging groove 31, so that a plurality of hanging heads of the hanging steel wire 42 spaced with one another vertically can be mounted in one transverse hanging groove 31.

As one embodiment, as shown in Fig.2, two pieces of safety steel wire 43 are also installed on the front surface of the screen 4, and the two pieces of safety steel wire 43 are positioned at both sides of the screen 4; the top ends of the safety steel wire 43 are directly fixed on the roller 3 (the safety steel wire on the left side of the figure is not shown), and the fixed pressing blocks of the safety steel wire 43 are arranged on the front surface of both ends of frame board bars 61; the supporting buffering pads press on the fixed pressing blocks of the safety steel wire 43 during winding the screen 4. The safety steel wire 43 curls as the screen 4 curls, and the deformation of the safety steel wire 43 is less than that of the steel wire inside the display units 41 of the screen 4; in this way, the force during curling is borne by the safety steel wire 43, so as to achieve the purpose of protecting the connecting steel wire inside the display units.

As one embodiment, the roller 3 is provided with a cable-arrangement groove 32 in the axis direction, and a plurality of cable outlets are set on an outer surface of the roller 3, so that some flat cable 94 connected to the screen 4 can led out from the cable outlets; in addition, the roller 3 is sleeved with rubber sleeves 33 in multi-section, which are positioned at both sides of the cable outlets. At the time of winding the screen 4, a flat cable 94 connected to the screen 4 are wound between two rubber sleeves 33, so as to avoid the flat cable from being directly squeezed by the screen and causing damage.

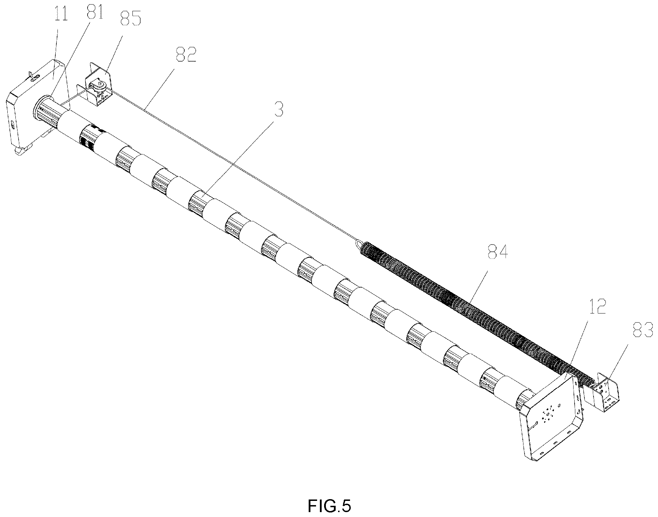

As a specific embodiment, as shown in Figs.5-7, the roller holder 1 includes a left-side plate 11 and a right-side plate 12, a driving assembly is installed on the right-side plate 12, and the driving assembly is connected with the right end of the roller 3 for driving the roller 3 to rotate. A bearing 71 is set on the left-side plate 11, and the inner ring of the bearing is fixed with the left-side plate 11, while the outer ring of the bearing is fixedly connected with the left end of the roller 3 through a connector, so that the roller 3 is rotatably connected between the left-side plate 11 and the right-side plate 12.

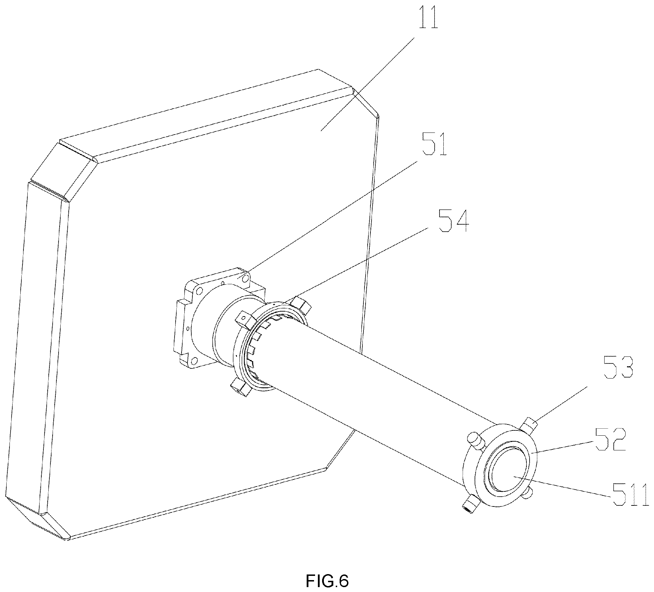

As shown in Fig.6, the driving assembly includes a motor 51 and a transmission sleeve 52. The motor 51 is installed on the right-side plate 12, and the rotating shaft 511 of the motor 51 is arranged inside the roller 3 and coaxial with the roller. The rotating shaft 511 is sleeved with the transmission sleeve 52, and engaging teeth are arranged between the rotating shaft 511 and the transmission sleeve 52, so that the transmission sleeve 52 rotates with the rotating shaft 511. An internally-threaded connecting column 53 is vertically set on an outer periphery surface of the transmission sleeve 52, and a position-restricting groove 34 is set on an inner wall of the roller 3 in the axial direction (Fig. 4). At the time of installing the motor 51, the internally-threaded connecting column 53 can slide along the position-restricting groove 34, and then is connected with the internally-threaded connecting column 53 disposed inside the position-restricting groove 34 by the way of passing a screw though a threaded hole or a through-hole on the outer surface of the roller 3, so that the transmission sleeve 52 is fixedly connected with the roller 3. A partial cylindrical tail of the motor 51 is also positioned inside the roller 3 and sleeved with a tail bearing 54. The outer ring of the tail bearing 54 is fixedly connected with the roller 3 by means of a screw, making it guaranteed that there is only a torque of rotation and no radial shear force on the rotating shaft of the motor 51, so as to protect the rotating shaft of the motor 51.

An upper-and-lower limit-stroke switch is set on the part of the motor 51 disposed outside the roller 3. It is used to adjust a limit stroke according to the length of the screen. The limit-stroke switch is a common switch in the prior art, which is used to operate the motor to rotate forwards and reversely and stop.

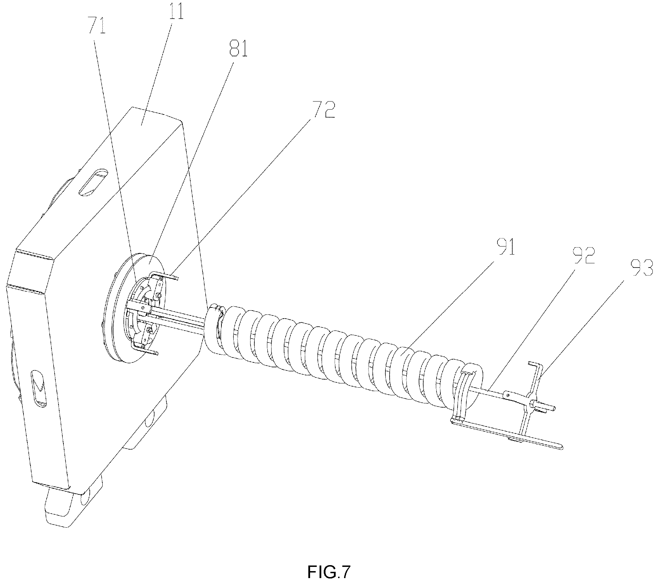

As shown in Fig.7, a bearing 71 is set on the left-side plate 11, and the inner ring of the bearing is fixed with the left-side plate 11, while the outer ring of the bearing is fixedly connected with the left end of the roller 3 through a connector, so that the roller 3 is rotatably connected between the left-side plate 11 and the right-side plate 12. The connector is a catching claw 72, which is fixed on a side surface of the outer ring of the bearing, and four jaws of the catching claw 72 are perpendicular to the plane of left-side plate 11, and inserted into the roller 3 along the axial direction of the roller 3 and fit on the inner wall of the roller 3; in addition, the end portion of the roller 3 is fixed with the catching claw by the way of fixing the roller 3 with the jaws of the catching claw 72 though a screw, that is, the end portion of the roller 3 is fixedly connected with the outer ring of the bearing, so that the roller 3 can rotate properly.

As shown in Figs.6-7, the rolling-up screen further comprises a motor-protecting mechanism, which includes reel partitions 81 that are positioned at the outer ring of the bearing and spaced with on another (two reel partitions 81 may be specifically installed on both sides of the outer ring of the bearing 71, that is, these two reel partitions 81 are arranged in an annular shape), a deflection sheave seat 85 and a spring-fixing piece 83 that are arranged on the frame 2, and a spring 84 and counterweight steel wire 82; the reel partitions 81 and the outer ring of the bearing 71 form a reel with a reel groove, and one end of the counterweight steel wire 82 is wound inside the reel groove; specifically, the end of the counterweight steel wire is fixed on the catching claw 72 and then penetrates into the reel groove from the through holes reserved on the reel partitions 81, and the counterweight steel wire 82 stretches out from the reel groove, and is connected to the spring 84 on the spring-fixing piece 83 by ways of getting turned through deflection sheaves of the deflection sheave seat 85. After the screen 4 has been retracted, the spring 84 is in a normal state; but when the screen 4 is unfolded, the motor 51 rotates and drives the roller 3 to rotate; thus, the roller 3 rotates to drive the reel to rotate, so that the counterweight steel wire 82 is being wound inside the reel until the screen 4 is completely unfolded; at this time, the spring 84 is in a tension state; when the screen 4 needs to be retracted, the motor 51 rotates and drives the roller 3 to rotate, and the delivery wire is released from the reel synchronously, so that the spring changes from the tension state to the normal state; in this way, the spring continues to change its tensile force in correspondence with the tightening of the counterweight steel wire, so as to just offset changes in torque of rolling the screen 4 for the roller 3, so that the motor 51 always maintains a low load torque to work, making it possible to reduce the load of the motor 51, and making the motor 51 run more smoothly.

As a specific embodiment, the power supply cord is configured in two modes as follows.

In the first example, as shown in Fig.7, a curled power supply cord 91 is arranged inside the role 3; meanwhile, a round rod 92 that is vertically inserted into the roller 3 through the bearing is fixed on the left-side plate 11, and the curled power supply cord 91 is wound around the round rod 92; the other end of the round rod is provided with a jaw disc 93, which is fixedly connected with the inner wall of the roller 3, and the center of the jaw disc 93 is provided with a hole which the round rod 92 penetrates. The connection end of the power supply cord 91 passes through the wire-inlet holes reserved on the bearing and the left-side plate 11, and is fixed on the outside of left-side plate 11, and the other end of the power supply cord 91 is connected to the power board that is arranged in the roller 3. When the roller 3 rotates, jaws of the jaw disc 93 can toggle the vertical part of the power supply cord and make the power supply cord rotate, and the curled power supply cord automatically stretches and retracts while the roller 3 is rotating; in this way, it does not affect fixing the connecting end of the power supply cord disposed on the left-side plate 11.

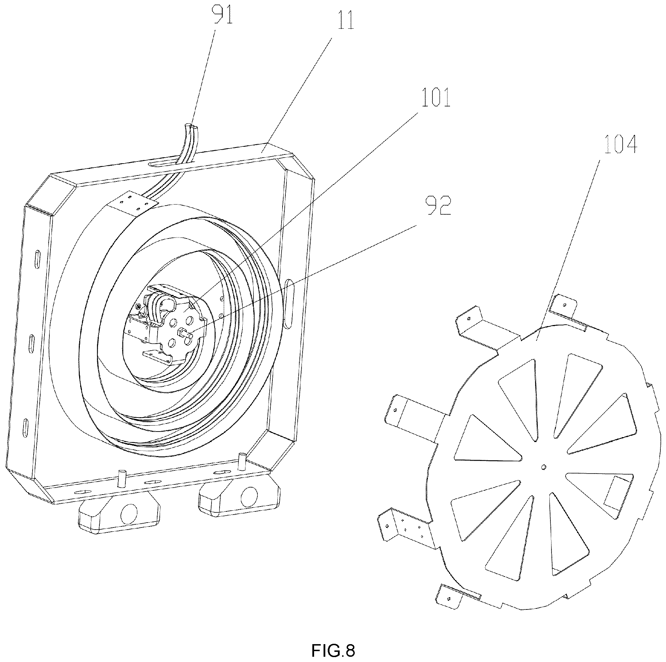

In the second example, as shown in Fig.8, a winding disc 101 is installed on an outer side surface of the left-side plate 11; meanwhile, one round rod 92 passes through the center of the winding disc 101 and is fixedly connected with the winding disc 101; in addition, the round rod is inserted into the roller 3 through the left-side plate 11, then fixedly connected with the jaw disc, which is fixedly connected with the inner wall of the roller 3; when the roller 3 rotates, it will drive the winding disc positioned at the outer side surface of the left-side plate 11 to rotate under the function of connecting with the aid of the round rod 92, and the power supply cord is drawn out along the round rod from the roller 3 and is fixed on the winding disc. A winding disk cover 104 that covers the winding disk inside is further installed on the outer side surface of the left-side plate 11, and an external cord-connecting disk lies inside the winding disk cover 4, and its end portion at the center is connected with the power supply cord (the external-connecting cord and the power supply cord are of one continuous cord in nature.). When the roller 3 rotates, the external-connecting cord rotates and stretches and retracts like a clockwork spring, so that the cable is not torn when rotating.

As shown in Figs.1-2, as a specific embodiment, side pulleys 63 are set on both sides of the screen 4; specifically, side pulleys 63 are arranged on both sides of each display unit 41, and a vertical guide rail in correspondence with the side pulleys is arranged on the frame 2. When the screen 4 is unfolded or retracted, the side pulleys will roll along the vertical guide rails, improving the stability of the screen 4 during unfolding and retracting it.

It should be noted that the terms used above are only used to describe specific embodiments and are not intended to pose any limitation on examples according to the present invention. As used herein, a singular noun is deemed as its plural, unless otherwise specified in the context; in addition, it is understandable that that, when the terms "contain" and/or "comprise" are used in this description, they involve features, steps, operations, devices, components and/or combinations thereof.

Unless otherwise specified, the relative arrangement, numerical expressions, and numerical values of the parts and steps described in these embodiments do not pose any limitation on the scope of the present invention. In addition, it should be understood that, for the sake of description, the dimensions of each part shown in the figures are not drawn in accordance with an actual measuring scale. It is not necessary to discuss the techniques, methods and apparatus known to a person skilled in the art may in detail, but in appropriate cases they shall be deemed as part of the description of the granted patent. In all the examples shown and discussed herein, any specific values should be interpreted as merely illustrative values and not as limitations. Therefore, other examples of exemplary embodiments can have different values. It should be noted that similar signs and letters present the same items as marked in the figures; in this way, once an item is defined in a figure, it does not need to be discussed further in subsequent figures.

It is understandable that as described in the present invention, the directional or positional relation indicated by the directional words such as "front, back, up, down, left, right", "horizontal, vertical, vertical, horizontal" and "top, bottom" are usually based on the directional or positional relation shown in the figures, and are only for the convenience of describing the present invention and simplifying the description; in the absence of reverse explanations, these directional words do not indicate or imply that the device or element referred to must involve a specific direction or make their forms and operate in a particular direction; therefore, these directional words cannot be construed as limitations on the protection scope of the present invention; the directional words "inside and outside" refer to the inside and outside of the contour with respect to each part itself.

For the sake of description, spatial terms such as "above", "over", "on" and "upper", are used to describe the spatial position of devices or features as shown in the figures and other devices or features. It should be understood that the spatial terms are intended to involve different discretions in use or operation in addition to those described in the figures. For example, if a device in the figure is inverted, this device described as "above other devices or arrangements" or "on other devices or arrangements" will be construed as "below other devices or arrangements" or "under other devices or constructions". Thus, the exemplary term "above" may involve two directions "above" and "below". The device may also be decided for its position in other different ways (turn by 90 degrees or in other directions), but the spatial terms used for description hereto also need to be construed in this way.

In addition, it should be noted that the words such as "first" and "second" used to define parts are only for the convenience of distinguishing the corresponding parts; unless otherwise specified, the above words have no special meaning, so they cannot be construed as limitations on the protection scope of the present invention.

Although embodiments of the present invention have been shown and described, they are not intended to pose any limitation on the present invention, it is understandable for a person killed in the art that a variety of changes, modifications, substitutions and variants may be made to these embodiments without departing from the principle and essence of the present invention, and they fall within the protection scope of the present invention.

## Claims

1. A rolling-up screen, **characterized in that** it comprises:
a roller holder connected to a ceiling by means of a frame, or supported by a frame;
a roller rotatably connected between a left-side plate and a right-side plate of said roller holder;
a screen including display units that are connected to one another upwards and downwards in multiple rows and connected with said roller by means of hanging steel wire, wherein said screen can be wound around said roller after retracting, and hung below said roller by said hanging steel wire after unfolding;
a driving assembly arranged on said roller holder and connected with said roller, wherein said driving assembly is used to drive said roller to rotate, so as to enable said screen to be retracted and wound on said roller or unfolded and hung below said roller; and
multiple groups of supporting protection pieces arranged on back surfaces of said display units in each row, and used to protect said display units during retracting said screen.

2. The rolling-up screen according to claim 1, **characterized in that** said supporting protection piece includes frame board bars arranged on the back surfaces of said display units in each row; and supporting buffering pads arranged at both ends of each of said frame board bars and beyond the positions of said display units, so that at the time of retracting said screen, one supporting buffering pad supports a frame board bar of another supporting protection piece, or stays against said roller.

3. The rolling-up screen according to claim 2, **characterized in that** a rubber piece is trapped within a gap between two adjacent ones of said frame board bars.

4. The rolling-up screen according to claim 1, **characterized in that** a hanging groove is set on an inner wall of said roller in the axis direction, said hanging groove is used to trap a hanging head of said hanging steel wire, and said hanging head is used to connect with said hanging steel wire.

5. The rolling-up screen according to claim 1, **characterized in that** safety steel wire hanging on said roller is installed on both sides of the back surface of said screen, and deformation of said safety steel wire is less than that of said hanging steel wire.

6. The rolling-up screen according to claim 1, **characterized in that** a cable-arrangement groove is set on an inner wall of said roller in the axis direction, a plurality of cable outlets leading to said cable-arrangement groove are set on an outer surface of said roller, and both sides of said cable outlet on said roller are sleeved with rubber sleeves.

7. The rolling-up screen according to claim 1, **characterized in that** said driving assembly includes a motor that is arranged on the right-side plate of said roller holder and positioned at one end of said roller, and a rotating shaft of said motor is inserted into said roller and connected with said roller.

8. The rolling-up screen according to claim 1, **characterized in that** the other end of said roller holder is arranged on the left-side plate of said roller holder, a bearing is arranged on the left-side plate, an inner ring of said bearing is fixedly connected with the left-side plate, and an outer ring of said bearing is connected with an end portion of said roller by means of a connector.

9. The rolling-up screen according to claim 8, **characterized in that** it further comprises a motor-protecting mechanism which includes:
reel partitions that are arranged on both sides of the outer ring of said bearing, wherein the outer ring of said bearing and two of said two reel partitions form a reel;
a deflection sheave seat and a spring-fixing piece that are arranged on said frame; and
counterweight steel wire getting turned via said deflection sheave seat, one end of which is connected with said reel, and the other end of which is connected with a spring on said spring-fixing piece.

10. The rolling-up screen according to claim 1, **characterized in that** side pulleys are arranged on both sides of said screen; and a vertical guide rail in correspondence with said side pulleys is arranged on said frame.
